# EUROPEAN PATENT APPLICATION

(11) **EP 4 663 645 A1**
(43) Date of publication of application: **17.12.2025**
(21) Application number: 25158695.4
(22) Date of filing: 18.02.2025
(51) Int. Cl.: C07F 7/22, H10K 10/46, H10K 85/50

(54) **TIN BASED PEROVSKITE FIELD EFFECT TRANSISTOR MEMORY AND METHOD OF MANUFACTURING SAME**

(30) Priority: 13.06.2024 KR 20240077021
(71) Applicant: POSTECH Research and Business Development Foundation, Pohang-si, Gyeongsangbuk-do 37673 (KR)
(72) Inventor: NOH, Yong Young, 37673 Pohang-si (KR); YOO, Soohwan, 37673 Pohang-si (KR)
(74) Representative: Stolmár & Partner Patentanwälte PartG mbB

(57) **Abstract**

Disclosed are tin-based perovskite field effect transistor memory and a method for manufacturing the same. In detail, a perovskite comprises at least one selected from the group consisting of cesium (Cs), methylammonium (MA), and formamidinium (FA); a compound represented by the structural formula 1; at least one selected from the group consisting of fluorine (F), chlorine (Cl), bromine (Br), and iodine (I); and tin (Sn). The transistor memory of the present invention can be utilized as a p-type transistor or a memory device, and can be utilized as a device for in-memory processing.

## Description

### CROSS REFERENCE TO RELATED APPLICATION

The present application claims priority to Korean Patent Application No. 10-2024-0077021, filed on June 13, 2024, the entire contents of which are incorporated herein for all purposes by this reference.

### BACKGROUND OF THE DISCLOSURE

### 1. Field of the Disclosure

The present invention relates to a tin-based perovskite field effect transistor memory and a method for manufacturing the same. In detail, an organic cation with two ammonium groups inducing a hollow is added to a tin-based perovskite thin film and the tin-based perovskite thin film is applied as a semiconductor active layer of a memory device. In addition, the present invention relates to a thin film transistor memory made using the active layer and a method for manufacturing the same.

### 2. Description of the Related Art

The development of industries such as machine learning and artificial intelligence (AI) is demanding semiconductors to be able to calculate and process increasingly large amounts of data at high speeds. The Von Neumann architecture, which is the basic structure of a typical computer, separates the processing unit that calculates and processes information from the memory unit. However, when processing a large amount of data, the amount of data that can be transferred between the processing unit and the memory unit is limited, which causes latency and requires a large amount of power consumption. In particular, in the increasingly important AI information processing, the latency of accessing data of the memory unit is a major bottleneck in performance.

Various ideas have been proposed to suppress such latency and excessive power consumption. Representatives among them are near-memory computing and in-memory computing. Near-memory computing refers to a circuit configuration method in which the processing unit and the memory unit are placed in a very close proximity, and a computation method through this. In general, both units are included on a single chip, or they are stacked vertically to minimize the distance that data travels back and forth, thus minimizing latency and power consumption. In the case of vertical stacking technology, it is already being applied and actively researched and developed in memory semiconductor devices such as HBM and HMC, and the M3D process is also being proposed for denser integration of memory units and processing units.

Another method, in-memory computing, is a computational memory unit that enables specific computational operations in the memory itself. In other words, since the process of round-tripping data between two distinct units and accessing and re-reading memory contents stored in the memory unit is eliminated, latency and power consumption can be dramatically reduced. In-memory computing has been implemented in memory devices such as DRAM, SRAM, and Flash memory, which are already actively used and studied in the industry, but there were limitations in scaling down due to large area occupancy and the requirement of large capacitors. Therefore, research is actively being conducted to implement in-memory computing by utilizing new types of memory devices such as resistive random access memory (RRAM) or phase-change random access memory (PRAM) rather than conventional MOSFET-based memory. In addition, single-transistor type memory is also being actively studied to utilize the highly integrated technology of conventional transistor processes, and recently, researches on devices in which a single transistor plays the role of memory have been reported. Representative research has been reported on transistor-type devices that can be utilized as both memory and transistor devices and high-density integration by utilizing transition metal dichalcogenide compounds with two-dimensional structure that can control electrostatic properties as a semiconductor active layer, and on PIM (Processing in Memory) semiconductors based on these. However, in the case of such two-dimensional transition metal dichalcogenide compounds, there is a limitation that the uniformity is poor and the process cost is high when produced in large area.

On the other hand, Halide Perovskite is a general term for materials with a chemical formula of ABX₃ and refers to materials with a unique crystal structure. Here, A is a monovalent organic/inorganic cation, B is a divalent inorganic cation, and X is a halogen anion. Inorganic or organic/inorganic mixed halide perovskites have high absorbance and excellent photoelectric properties, so they have been mainly used as light absorbers for solar cells. In addition, various types of organic/inorganic cations and anions can be used, and many can be used at once. Optical and electrical properties can be easily controlled through the combination of various components, so they can be used as various electronic materials and photoelectric materials. In addition, since thin film manufacturing and device manufacturing are possible through simple processes such as simple solution processes and thermal deposition processes, they are attracting attention industrially and academically in various fields. Therefore, based on these advantages, research is also actively being conducted recently to utilize them as semiconductor layers of thin film transistors (TFTs) or memory semiconductors. Perovskite-based memory semiconductor research is mainly focused on resistive memory utilizing anion vacancies, but compared to resistive memory based on other semiconductor materials comprising oxide semiconductors, data storage is relatively unstable and operation speed is slow. Therefore, it is necessary to overcome these.

In addition, resistive memory, which is relatively stable and performs well, is generally concentrated on toxic lead-based perovskite devices. Therefore, in order to commercialize, it is an important task to develop a lead-free halide perovskite material that shows better performance and stability. Lead-free perovskites are also being studied in various ways, and among them, tin is presented as a candidate for a relatively stable perovskite B cation because it is harmless to the human body or the environment, is an element of the same group as lead, and has a similar size. In addition, tin-based halide perovskite has excellent electrical properties such as low effective hole mass and high hole mobility, and it is attracting attention as next-generation p-type semiconductors that can be used as a channel layer of a p-type transistor. In addition, just like lead-based perovskites, various cation and anion materials can be applied, and the electrical properties can be easily adjusted through combination changes, and memory characteristics can be achieved by adjusting the type and amount of additives. In addition, thin film manufacturing and device fabrication are possible on desired parts of the wafer through simple processes such as thermal deposition processes. Therefore, based on these advantages, the tin-based halide perovskite can also be used as semiconductor active layers of memory semiconductors for in-memory computing.

As above, tin-based perovskites have excellent electrical properties among lead-free perovskite materials, but unlike lead, tin is easily oxidized from Sn²⁺ to Sn⁴⁺ by moisture and oxygen in the air, which induces the formation of tin vacancies in tin-based halide perovskites. The tin vacancies that are also created during the thin film formation process play a role in increasing the amount of holes by creating shallow traps near the valence band maximum (VBM) of tin-based halide perovskites. However, when there are too many of them, the concentration of holes becomes too high to make on and off, and inducing instability of the lattice, and eventually the tin-based perovskites lose their excellent electrical properties.

Therefore, in order to use these tin-based perovskite thin films as stable semiconductor active layers of transistors, memory devices, solar cells, LEDs, light-emitting devices, and photo receiving devices, etc., the technology to suppress and control the formation of tin vacancies and the oxidation of tin. is needed.

### SUMMARY OF THE DISCLOSURE

The purpose of the present disclosure is to form a tin-based halide perovskite thin film having a hollow structure by adding diammonium organic cation, and to provide a thin film transistor memory having memory characteristics capable of stably storing information and a method for manufacturing the same by using the thin film transistor memory.

In addition, another purpose of the present disclosure is to provide a thin film transistor memory that is easy to industrialize, comprising a semiconductor layer that does not comprise lead and instead comprises tin ions, which are environmentally friendly materials, as cations.

The present disclosure provides a perovskite comprising: at least one selected from the group consisting of cesium (Cs), methylammonium (MA), and formamidinium (FA); a compound represented by structural formula 1; at least one selected from the group consisting of fluorine (F), chlorine (Cl), bromine (Br), and iodine (I); and tin (Sn). 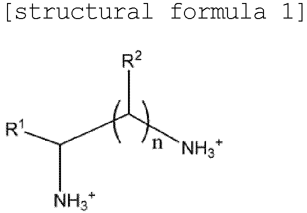 in the structural formula 1, R¹ is a hydrogen atom, a methyl group, or an ethyl group, R² is a hydrogen atom, a methyl group, or an ethyl group, and n is anyone of integers 1 to 3.

In addition, the compound represented by the structural formula 1 may comprise at least one selected from the group consisting of EDA (ethane-1,2-diammonium), P2DA (propane-1,2-diammonium), P3DA (propane-1, 3-diammonium), Piperazine-1,4-diium iodide, Piperazine-1,4-diium chloride and Piperazine-1,4-diium bromide.

In addition, the perovskite may have a hollow structure within a lattice.

In addition, the perovskite may further comprise a compound represented by the structural formula 2. 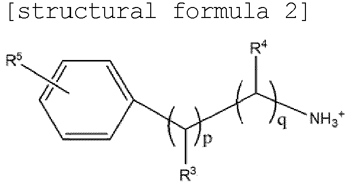 in the structural formula 2, R³ is a hydrogen atom, a methyl group, or an ethyl group, R⁴ is a hydrogen atom, a methyl group or an ethyl group, R⁵ is a hydrogen atom, a methyl group, an ethyl group, a C6 to C10 aryl group or a C6 to C14 aryl group fused to the benzene ring, p is anyone of integers 0 to 3, and q is anyone of integers 1 to 3.

In addition, the perovskite may comprise 0.1 to 100 mol of at least one selected from the group consisting of the compound represented by the structural formula 1 and the compound represented by the structural formula 2 on the basis of 100 mol of the tin.

In addition, the perovskite may have a 2D/3D (quasi 2D) structure.

In addition, the compound represented by the structural formula 2 may be located on a surface of the perovskite crystal.

In addition, the perovskite may comprise grain boundary formed between a grain and a neighboring grain, wherein at least one metal fluoride compound selected from the group consisting of SnF₂ and SbF₃ may be located at the grain boundary.

In addition, the perovskite may be used in a semiconductor layer of at least one selected from the group consisting of a memory device, a transistor, a solar cell, a light-emitting diodes, a photodiode, and a photosensor.

In addition, a thickness of the semiconductor layer may be in a range of 1 to 100 nm.

Another aspect of the present disclosure provides a transistor memory comprising: a gate electrode 100; an insulating layer 200 located on the gate electrode; a semiconductor layer 300 comprising a perovskite located on the insulating layer and; and a source electrode 400 and a drain electrode 500 located at a distance from each other on the semiconductor layer.

In addition, the perovskite may comprise: at least one selected from the group consisting of cesium (Cs), methylammonium (MA), and formamidinium (FA); a compound represented by structural formula 1; at least one selected from the group consisting of fluorine (F), chlorine (Cl), bromine (Br), and iodine (I); and tin (Sn). 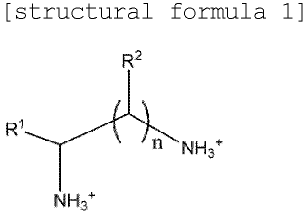 in the structural formula 1, R¹ is a hydrogen atom, a methyl group, or an ethyl group, R² is a hydrogen atom, a methyl group, or an ethyl group, and n is anyone of integers 1 to 3.

Another aspect of the present disclosure provides a method of preparing a perovskite comprising: (a) preparing a precursor solution comprising a tin precursor, a compound represented by structural formula 1', a solvent and at least one selected from the group consisting of a cesium (Cs) precursor, a methylammonium (MA) precursor and a formamidinium (FA) precursor; (b) coating the precursor solution on a substrate to form a coating layer; and (c) heat-treating the coating layer to prepare a perovskite. 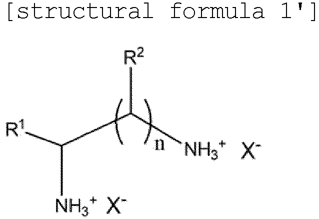 in the structural formula 1', R¹ is a hydrogen atom, a methyl group, or an ethyl group, R² is a hydrogen atom, a methyl group, or an ethyl group, X is F, Cl, Br or I, and n is anyone of integers 1 to 3.

In addition, the perovskite may comprise at least one selected from the group consisting of cesium (Cs), methylammonium (MA), and formamidinium (FA); a compound represented by structural formula 1; at least one selected from the group consisting of fluorine (F), chlorine (Cl), bromine (Br), and iodine (I); and tin (Sn). 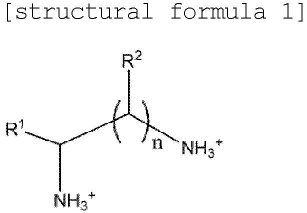 in structural formula 1, R¹ is a hydrogen atom, a methyl group, or an ethyl group, R² is a hydrogen atom, a methyl group, or an ethyl group, and n is anyone of integers 1 to 3.

In addition, the compound represented by the structural formula 1' may comprise at least one selected from the group consisting of EDAI₂ (ethane-1,2-diammonium diiodide), EDABr₂ (ethane-1,2-diammonium dibromide), P2DAI₂ (propane-1,2-diammonium diiodide), P2DABr₂ (propane-1,2-diammonium dibromide), P3DAI₂ (propane-1,3-diammonium diiodide) and P3DABr₂ (propane-1,3-diammonium) .

In addition, the precursor solution may further comprise a compound represented by structural formula 2'. 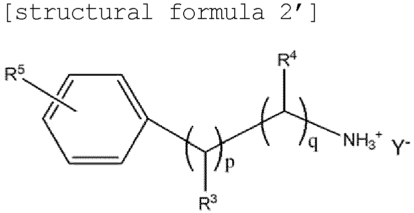 in the structural formula 2', R³ is a hydrogen atom, a methyl group, or an ethyl group, R⁴ is a hydrogen atom, a methyl group or an ethyl group, R⁵ is a hydrogen atom, a methyl group, an ethyl group, a C6 to C10 aryl group or a C6 to C14 aryl group fused to the benzene ring, Y 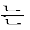 F, Cl, Br or I, p is anyone of integers 0 to 3, and q is anyone of integers 1 to 3.

In addition, the compound represented by the structural formula 2' may comprise at least one selected from the group consisting of PEAI (phenylethylammonium iodide), BAI (n-butylammonium iodide) and NMAI (1-naphthylmethylammonium iodide).

In addition, the coating of the step (b) may be carried out by at least one method selected from the group consisting of spin coating, bar coating, slot coating, inkjet coating, spray coating, dispensing, thermal evaporation, chemical vapor deposition (CVD), atomic layer deposition (ALD), sputtering, flexography, screen, dip-coating, and gravure methods.

In addition, the heat treatment of the step (c) may be carried out at a temperature in a range of room temperature to 200°C.

Another aspect of the present disclosure provides a method of manufacturing a transistor memory, the method may comprise: (1) preparing a gate electrode/insulating layer laminate comprising a gate electrode and an insulating layer located on the gate electrode; (2) forming a semiconductor layer comprising a perovskite according to claim 1 on the insulating layer; and (3) forming a source electrode and a drain electrode on the semiconductor layer.

The thin film transistor memory of the present invention can be utilized as a p-type transistor and a memory device, and can be utilized as device for in-memory processing.

In addition, the thin film is an eco-friendly material based on tin, not lead, and is easy to industrialize.

In addition, the thin film transistor memory of the present invention induces the formation of a hollow structure by adding an additive comprising a diammonium halide compound, which induces the formation of a deep trap in the channel and can provide a high-performance memory device that exhibits a long information retention time and strong endurance at a low driving voltage.

In addition, by expanding the bandgap and lowering the VBM level, it is possible to suppress the oxidation of tin and the formation of vacancies and control the concentration of holes, and by acting as a crystallization retardant in the process of forming a thin film, it can induce the improvement of crystallinity, grain boundary obscuration, etc., and provide a transistor memory with stability, reproducibility, and uniformity.

In addition, the present invention can suppress the oxidation of tin and the formation of vacancies and control the concentration of holes by adding an additive comprising an ammonium iodide compound, so it can provide a stable and reproducible transistor memory.

In addition, the present invention can suppress the oxidation of tin and the formation of pores and control the concentration of holes by adding an additive comprising a metal fluoride compound, and can provide a transistor memory having stability, reproducibility, and uniformity by acting as a crystal nucleus to form a uniform and highly crystalline thin film.

### BRIEF DESCRIPTION OF THE DRAWINGS

Since the accompanying drawings are intended to illustrate exemplary embodiments of the present disclosure, the technical ideas of the present invention should not be construed to be limited by the accompanying drawings.
FIG. 1 is a schematic diagram of a thin film transistor memory according to one embodiment of the present invention.
FIG. 2 is a flow chart showing a manufacturing process diagram of a thin film transistor memory according to one embodiment of the present invention.
FIG. 3 is the XRD analysis showing results of Examples 1-1, 1-2, and 1-3 and Comparative Example 1.
FIG. 4A shows the absorbance analysis showing results of Examples 1-1, 1-2 and Comparative Example 1.
FIG. 4B shows the results of Tauc plot extrapolation for deriving the optical bandgap of Examples 1-1, 1-2 and Comparative Example 1.
FIG. 5 shows the current curves (output curve) of Device Example 1-1 and Device Comparative Example 1.
FIG. 6 shows the transfer curves of Device Example 1-1 and Device Comparative Example 1 when VDS = -5 V is set.
FIG. 7 shows the transfer curves of device examples 1-1 to 1-3 and device comparative example 1 when V_{DS} = -0.5 V is set.
FIG. 8 shows the results of measuring the retention time of stored information for device example 1-1.
FIG. 9 shows the results of measuring the cycling endurance for device example 1-1.
FIG. 10 shows the basic structure of perovskite.

### DESCRIPTION OF THE PREFERRED EMBODIMENTS

Herein after, embodiments of the present disclosure will be described in detail with reference to the accompanying drawings in such a manner that the ordinarily skilled in the art can easily implement the embodiments of the present disclosure.

The description given below is not intended to limit the present disclosure to specific embodiments. In relation to describing the present disclosure, when the detailed description of the relevant known technology is determined to unnecessarily obscure the gist of the present disclosure, the detailed description may be omitted.

The terminology used herein is for the purpose of describing particular embodiments only and is not intended to limit the scope of the present disclosure. As used herein, the singular forms "a", "an", and "the" are intended to comprise the plural forms as well unless the context clearly indicates otherwise. It will be further understood that the terms "comprise" or "have" when used in the present disclosure specify the presence of stated features, integers, steps, operations, elements and/or combinations thereof, but do not preclude the presence or addition of one or more other features, integers, steps, operations, elements, and/or combinations thereof.

Terms comprising ordinal numbers used in the specification, "first", "second", etc. can be used to discriminate one component from another component, but the order or priority of the components is not limited by the terms unless specifically stated. These terms are used only for the purpose of distinguishing a component from another component. For example, without departing from the scope of the present disclosure, a first component may be referred to as a second component, and a second component may be also referred to as a first component.

In addition, when it is mentioned that a component is "formed" or "stacked" on another component, it should be understood such that one component may be directly attached to or directly stacked on the front surface or one surface of the other component, or an additional component may be disposed between them.

Hereinafter, the embodiment of the present disclosure shall be explained with reference to the attached drawing, and in describing it by reference to the accompanying drawing, the same or corresponding components shall be given the same figure number and the duplicate description thereof shall be omitted.

Tin based perovskite field effect transistor memory and method of manufacturing same will be described in detail. However, those are described as examples, and the present disclosure is not limited thereto and is only defined by the scope of the appended claims.

One aspect of the present disclosure provides a perovskite comprising: at least one selected from the group consisting of cesium (Cs), methylammonium (MA), and formamidinium (FA); a compound represented by structural formula 1; at least one selected from the group consisting of fluorine (F), chlorine (Cl), bromine (Br), and iodine (I); and tin (Sn). 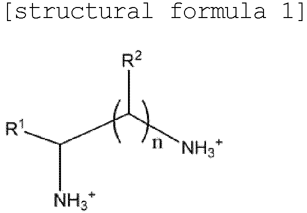 in the structural formula 1, R¹ is a hydrogen atom, a methyl group, or an ethyl group, R² is a hydrogen atom, a methyl group, or an ethyl group, and n is anyone of integers 1 to 3.

In addition, the compound represented by the structural formula 1 may comprise at least one selected from the group consisting of EDA (ethane-1,2-diammonium), P2DA (propane-1,2-diammonium), P3DA (propane-1,3-diammonium), Piperazine-1,4-diium iodide, Piperazine-1,4-diium chloride and Piperazine-1,4-diium bromide.

In addition, the compound represented by the structural formula 1 can induce memory characteristics by forming a hollow structure in the lattice, and lower the level of VBM (Valence Band Maximum) to promote stability through oxidation inhibition.

In addition, the perovskite composite may comprise 0.05 to 20 mol, preferably 0.1 to 10 mol, and more preferably 0.1 to 5 mol of the compound represented by the structural formula 1, based on 100 mol of tin of the tin-based perovskite.

When the perovskite composite comprises less than 0.05 mol of the compound represented by the structural formula 1, based on 100 mol of tin of the tin-based perovskite, the hollow structure is not sufficiently formed, so that the memory characteristics are not exhibited, which is undesirable. When it comprises more than 20 mol, the hollow structure is no longer formed, and the surface or grain boundaries of the lattice are present, or the lattice is destabilized, so that the electrical characteristics of the device are deteriorated, which is undesirable.

In addition, the metal fluoride compound can suppress the oxidation of tin and the generation of vacancy defects, control the hole concentration, and provide even crystal nuclei to generate a stable, uniform, and highly crystalline thin film crystal.

In addition, the metal fluoride compound may be comprised in an amount of 0.01 to 50 mol, preferably 1 to 20 mol.

When the metal fluoride compound is comprised in an amount of less than 0.01 mol based on 100 mol of tin in the tin-based perovskite, the oxidation inhibition and hole concentration reduction effects are insignificant, so the off current may be high and the memory characteristics may not be obtained, which is undesirable. When it is comprised in an amount exceeding 50 mol, the problem of phase separation may occur due to the agglomeration of the metal fluoride compound, which is undesirable.

In addition, the perovskite may have a hollow structure within the lattice.

In addition, the perovskite further may further comprise a compound represented by the structural formula 2. 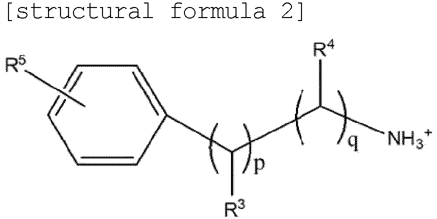 in the structural formula 2, R³ is a hydrogen atom, a methyl group, or an ethyl group, R⁴ is a hydrogen atom, a methyl group or an ethyl group, R⁵ is a hydrogen atom, a methyl group, an ethyl group, a C6 to C10 aryl group or a C6 to C14 aryl group fused to the benzene ring, p is anyone of integers 0 to 3, and q is anyone of integers 1 to 3.

In addition, the perovskite may comprise 0.1 to 100 mol, preferably 0.1 to 50 mol, and more preferably 0.1 to 30 mol, of at least one selected from the group consisting of a compound represented by the structural formula 1 and a compound represented by the structural formula 2, based on 100 mol of tin.

In addition, the perovskite may have a 2D/3D (quasi 2D) structure.

The 2D/3D (quasi 2D) structure is an intermediate structure between 2D and 3D perovskite, and refers to a plate-shaped crystal structure with a limited thickness by an additive represented by structural formula 2. The structure can be described by the chemical formula of A'₂Aₙ₋₁BₙX₃ₙ₊₁, where A' may comprise at least one selected from the group consisting of a compound represented by structural formula 2, A may comprise at least one selected from the group consisting of cesium (Cs), methylammonium (MA), and formamidinium (FA), B is tin (Sn), and X may comprise at least one selected from the group consisting of fluorine (F), chlorine (Cl), bromine (Br), and iodine (I). Also, in the chemical formula, when n = 1, it is a 2D structure, when n = ∞, it is a 3D structure, and when it has a specific natural number value in between 1 and ∞, it is called a 2D/3D (quasi 2D) structure.

In addition, the compound represented by the structural formula 2 may be located on the surface of the perovskite crystal.

In addition, the compound represented by the structural formula 2 can play a role in suppressing tin oxidation and vacancy defect generation and controlling hole concentration by inducing a 2D/3D mixed perovskite structure by introducing PEA or BA or NMA into the lattice.

In addition, the perovskite may comprise a grain boundary formed between a grain and a neighboring grain, and at least one selected from the group consisting of SnF₂ and SbF₃ may be located at the grain boundary.

In addition, the metal fluoride compound can control the hole concentration by suppressing the oxidation of tin and the generation of vacancy defects and provide uniform crystal nuclei to form a stable, uniform, and highly crystalline thin film crystal.

In addition, the compound represented by the structural formula 1, 2 and the metal fluoride compound may comprise any one selected from the group consisting of EDAI₂, EDABr2, P2DAI₂, P2DABr₂, P3DAI₂, and P3DABr₂, or at least one selected from the group consisting of PEAI :EDAI₂:SnF₂, BAI:EDAI₂: SnF₂, NMAI:EDAI₂: SnF₂, PEAI:EDABr₂:SnF₂, BAI:EDABr₂:SnF₂, NMAI:EDABr₂:SnF₂, PEAI:P2DAI₂:SnF₂, BAI:P2DAI₂:SnF₂, NMAI:P2DAI₂:SnF₂, PEAI : P2DABr₂:SnF₂, BAI:P2DABr₂:SnF₂, NMAI:P2DABr₂:SnF₂, PEAI : P3DAI₂:SnF₂, BAI:P3DAI₂:SnF₂, NMAI: P3DAI₂:SnF₂, PEAI : P3DABr₂:SnF₂, BAI:P3DABr₂:SnF₂, NMAI:P3DABr₂:SnF₂, PEAI : EDAI₂: SbF₃, BAI:EDAI₂: SbF₃, NMAI:EDAI₂: SbF₃, PEAI : EDABr₂:SbF₃, BAI:EDABr₂:SbF₃, NMAI:EDABr₂:SbF₃, PEAI:P2DAI₂:SbF₃, BAI:P2DAI₂:SbF₃, NMAI: P2DAI₂:SbF₃, PEAI : P2DABr₂:SbF₃, BAI:P2DABr₂:SbF₃, NMAI:P2DABr₂:SbF₃, PEAI:P3DAI₂:SbF₃, BAI: P3DAI₂:SbF₃, NMAI:P3DAI₂:SbF₃, PEAI : P3DABr₂:SbF₃, and BAI: P3DABr₂:SbF₃, NMAI:P3DABr₂:SbF₃.

In addition, the tin-based perovskite may comprise at least one selected from the group consisting of formamidinium tin triiodide (FASnI₃), cesium tin triiodide (CsSnI₃), methylammonium tin triiodide (MASnI₃), phenylethylammonium formamidinium tin triiodide (PEAFASnI₃), and cesium formamidinium tin triiodide (CsFASnI₃).

In addition, the perovskite may be used in a semiconductor layer of at least one selected from the group consisting of a memory device, a transistor, a solar cell, a light-emitting diodes, a photodiode, and a photosensor, and particularly preferably may be used as an active layer of a memory device.

In addition, the thickness of the semiconductor layer may be 1 to 100 nm, preferably 3 to 50 nm. When the thickness of the semiconductor layer is less than 1 nm, it is difficult to apply it over the entire surface of the substrate, which is undesirable, and when it exceeds 100 nm, it has excessive charge and shows unstable memory characteristics, which is undesirable. Since it is formed with such a very thin structure, the memory device can be implemented in flexible applications.

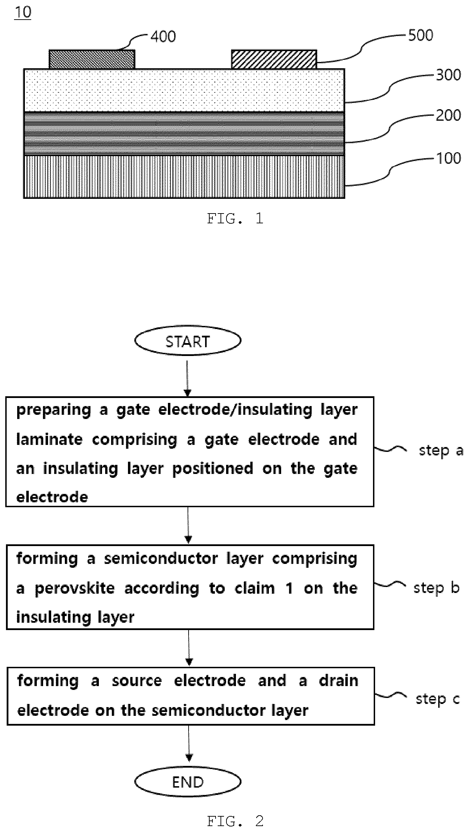

FIG. 1 is a schematic diagram of a thin film transistor memory according to one embodiment of the present invention, FIG. 2 is a flow chart showing a manufacturing process diagram of a thin film transistor memory according to one embodiment of the present invention.

Referring to FIG. 1, the present disclosure provides a transistor memory comprising: a gate electrode 100; an insulating layer 200 located on the gate electrode; a semiconductor layer 300 comprising a perovskite located on the insulating layer and; and a source electrode 400 and a drain electrode 500 located at a distance from each other on the semiconductor layer.

In addition, the perovskite may comprise: at least one selected from the group consisting of cesium (Cs), methylammonium (MA), and formamidinium (FA); a compound represented by structural formula 1; at least one selected from the group consisting of fluorine (F), chlorine (Cl), bromine (Br), and iodine (I); and tin (Sn). 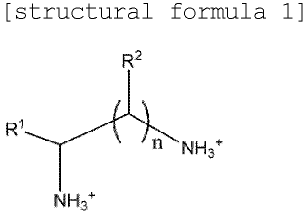 in the structural formula 1, R¹ is a hydrogen atom, a methyl group, or an ethyl group, R² is a hydrogen atom, a methyl group, or an ethyl group, and n is anyone of integers 1 to **3.**

The thin film transistor memory of the present invention may further comprise a substrate, or a substrate comprising the gate electrode, as needed. The thin film transistor memory (10) is described in the BGTC (Bottom Gate Top Contact) structure, but is not limited thereto, and may also be applied to a TGBC (Top Gate Bottom Contact) structure, etc., and is not limited thereto. The bottom-type thin film transistor memory is comprised the steps of providing a substrate, forming a gate electrode on the substrate, forming an insulating layer on the gate electrode, forming a semiconductor layer on the insulating layer, and forming a source electrode and a drain electrode spaced apart from each other on an organic semiconductor layer.

Also, the substrate may comprise, but is not limited to, a silicon wafer doped with n-type or p-type, a glass substrate, a plastic film comprising at least one selected from the group consisting of polyacrylate, polyimide, polyetherimide, polyethylene terepthalate, polyethylene naphthalate, and polyethersulphone, a glass substrate or a plastic film coated with indium tin oxide.

In addition, the gate electrode 100 may comprise at least one selected from the group consisting of gold (Au), silver (Ag), aluminum (Al), aluminum alloy (Al-alloy), molybdenum (Mo), molybdenum alloy (Mo-alloy), n-doped silicon (n-doped Si), p-doped silicon (p-doped Si), silver nanowire, gallium indium eutectic, platinum (Pt), nickel (Ni), titanium (Ti), tungsten (W), chromium (Cr), magnesium (Mg), calcium (Ca), ytterbium (Yb), gold oxide, platinum oxide, silver oxide, palladium oxide, iron oxide, graphene, carbon nanotube (CNT), indium tin oxide, and PEDOT:PSS (poly(3,4-ethylenedioxythiophene), polystyrene sulfonic acid and poly(3,4-ethylenedioxythiophene) polystyrene sulfonate). The gate electrode can be formed by adopting at least one selected from the group consisting of thermal evaporation, sputtering and spin coating.

In addition, the gate insulating layer 200 may be formed on over the entire surface of the gate electrode 100. The gate insulating layer 200 may be included as a single or multi-layer membrane of an inorganic insulating film or an organic insulating film, or as an organic-inorganic hybrid film. As the inorganic insulating film, at least one selected from the group consisting of a silicon oxide film, a silicon nitride film, hafnium oxide (HfO₂), alumina (Al₂O₃), tantalum oxide (Ta₂O₅), zirconium oxide (ZrO₂), BST (Barium Strontium Titanate), PZT (Pb(Zr, Ti)O₃), glass, quartz, silicon carbide, magnesium oxide, and germanium may be used. As the organic insulating film, at least one selected from the group comprising polymethylmethacrylate (PMMA), polystyrene (PS), phenol-based polymers, acrylic-based polymers, imide-based polymers such as polyimide, aryl ether-based polymers, amide-based polymers, fluorine-based polymers, p-xyrilene-based polymers, vinyl alcohol-based polymers, and parylene may be used.

In addition, the semiconductor layer 300 can be formed on the entire surface of the insulating layer 200. The semiconductor layer 300 may comprise formamidinium tin triiodide (FASnI₃), cesium tin triiodide (CsSnI₃), methylammonium tin triiodide (MASnI₃), PEAFASnI₃, CsFASnI₃, or PEACsFASnI₃ which are mixtures of FASnI₃ and cation. A method of forming a semiconductor layer 300 on an insulating layer 200 may comprise at least one selected from the group consisting of a solution process (spin coating, bar coating, slot coating, inkjet, spray coating, dispensing, etc.), thermal evaporation, and a mixed process (two step process: solution process followed by vacuum deposition or vacuum deposition followed by solution process), chemical vapor deposition (CVD), atomic layer deposition (ALD), sputtering, flexography, screen, dip-coating, and gravure method, preferably spin coating, bar coating, and thermal deposition, and more preferably spin coating process,.

Here, when the substrate is comprised, the temperature of the substrate in the thermal deposition process may be at a temperature in a range of room temperature to 300°C.

In addition, heat treatment or optical exposure, etc. may be further performed after the formation of the semiconductor layer 300 to improve the device performance such as semiconductor crystallinity and stability.

In addition, the source electrode 400 and drain electrode 500 may be formed as a single layer comprising at least one selected from the group consisting of Au, Ag, Pt, Al, W, Mg, Ca, Yb, Mo, alloy thereof, Cs-ITO, gold oxide, platinum oxide, silver oxide, palladium oxide, iron oxide and indium tin oxide (ITO).

In addition, when the substrate is comprised, in order to improve adhesion with the substrate, an adhesive metal layer such as Ti, Cr or Ni may be further comprised to form a multilayer. In addition, it is possible to manufacture more elastic and flexible devices than existing metals using conductive polymers such as graphene, carbon nanotubes (CNTs), PEDOT:PSS, and silver nanowires.

Another aspect of the present invention provides a method of preparing a perovskite comprising: (a) preparing a precursor solution comprising a tin precursor, a compound represented by structural formula 1', a solvent and at least one selected from the group consisting of a cesium (Cs) precursor, a methylammonium (MA) precursor and a formamidinium (FA) precursor; (b) coating the precursor solution on a substrate to form a coating layer; and (c) heat-treating the coating layer to prepare a perovskite. 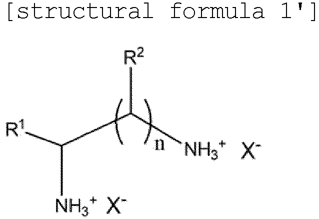 in the structural formula 1', R¹ is a hydrogen atom, a methyl group or an ethyl group, R² is a hydrogen atom, a methyl group, or an ethyl group, X is F, Cl, Br or I and n is anyone of integers 1 to 3.

In addition, the perovskite may comprise at least one selected from the group consisting of cesium (Cs), methylammonium (MA) and formamidinium (FA); a compound represented by structural formula 1; at least one selected from the group consisting of fluorine (F), chlorine (Cl), bromine (Br), and iodine (I); and tin (Sn). 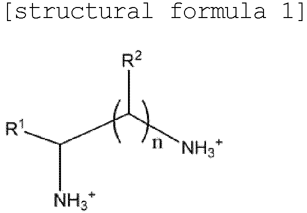 in the structural formula 1, R¹ is a hydrogen atom, a methyl group or an ethyl group, R² is a hydrogen atom, a methyl group or an ethyl group, and n is anyone of integers 1 to 3.

In addition, the compound represented by the structural formula 1' may comprise at least one selected from the group consisting of EDAI₂ (ethane-1,2-diammonium diiodide), EDABr₂ (ethane-1,2-diammonium dibromide), P2DAI₂ (propane-1,2-diammonium diiodide), P2DABr₂ (propane-1,2-diammonium dibromide), P3DAI₂ (propane-1,3-diammonium diiodide) and P3DABr₂ (propane-1,3-diammonium) .

In addition, the compound represented by the structural formula 1' may play a role in inducing memory characteristics by forming a hollow structure within the lattice and enhancing stability through oxidation inhibition by lowering the level of VBM (Valence Band Maximum).

In addition, the precursor solution may further comprise a compound represented by structural formula 2'. 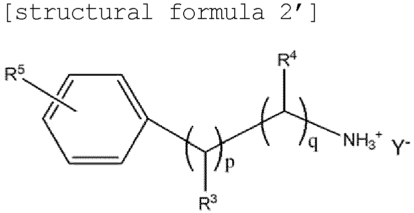 in the structural formula 2', R³ is a hydrogen atom, a methyl group or an ethyl group, R⁴ is a hydrogen atom, a methyl group or an ethyl group, R⁵ is a hydrogen atom, a methyl group, an ethyl group, a C6 to C10 aryl group or a C6 to C14 aryl group fused to the benzene ring, Y 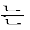 F, Cl, Br or I, p is anyone of integers 0 to 3, and q is anyone of integers 1 to 3.

In addition, the compound represented by the structural formula 2' may comprise at least one selected from the group consisting of PEAI (phenylethylammonium iodide), BAI (n-butylammonium iodide) and NMAI (1-naphthylmethylammonium iodide).

In addition, the compound represented by the structural formula 2' may play a role in suppressing tin oxidation and vacancy defect generation, and controlling hole concentration by inducing a 2D/3D mixed perovskite structure by introducing PEA or BA or NMA into the lattice.

The present invention is comprising a compound denoted by the structural formula 1, a compound denoted by structural formula 2, and a metal fluoride compound, which suppresses the generation of oxidation and pore defects, thereby controlling the hole concentration and improving stability, improving crystallinity, and imparting memory characteristics to form an optimal memory semiconductor thin film. In particular, the role of the compound represented by the structural formula 1 and the metal fluoride compound is significant.

Here, the ammonium iodide based additive, the diammonium halide based additive, and the metal fluoride based additive commonly suppress the oxidation of tin and the generation of vacancy defects, and control the hole concentration when manufacturing a thin film through spin coating. In addition, the diammonium halide based additive forms a hollow structure in the thin film local area to induce a deep trap, thereby imparting memory characteristics to the thin film crystal, and the metal fluoride based additive can provide uniform crystal nuclei to induce the formation of a stable, uniform, and highly crystalline thin film crystal.

In addition, the perovskite may comprise 0.1 to 100 mol, preferably 0.1 to 50 mol, and more preferably 0.1 to 30 mol of at least one selected from the group consisting of a compound represented by the structural formula 1 and a compound represented by the structural formula 2, based on 100 mol of tin.

In addition, the perovskite composite may comprise 0.05 to 20 mol, preferably 0.1 to 10 mol, and more preferably 0.1 to 5 mol of the compound represented by the structural formula 1, based on 100 mol of tin of the tin-based perovskite.

When the perovskite composite contains less than 0.05 mol of the compound represented by the structural formula 1, based on 100 mol of tin of the tin-based perovskite, the hollow structure is not sufficiently formed, so that the memory characteristics are not exhibited, which is undesirable. When it contains more than 20 mol, the hollow structure is no longer formed, and the problem of the electrical characteristics of the device being deteriorated by existing on the surface or grain boundaries of the lattice or inducing instability of the lattice may occur, which is undesirable.

In addition, the metal fluoride compound may be comprised in an amount of 0.01 to 50 mol, preferably 1 to 20 mol.

When the metal fluoride compound is comprised in an amount of less than 0.01 mol based on 100 mol of tin in the tin-based perovskite, the oxidation inhibition and hole concentration reduction effects are insignificant, so the off current may be high and the memory characteristics may not be present, which is undesirable. When it is comprised in an amount exceeding 50 mol, a problem of phase separation may occur due to agglomeration of the fluoride metal compound, which is undesirable.

In addition, the step (b) may be performed by a method comprising at least one selected from the group consisting of a solution process (spin coating, bar coating, slot coating, inkjet, spray coating, dispensing, etc.), thermal evaporation, and a mixed process (two step process: solution process followed by vacuum deposition or vacuum deposition followed by solution process), chemical vapor deposition (CVD), atomic layer deposition (ALD), sputtering, flexography, screen, dip-coating, and gravure methods, preferably a spin coating method.

In addition, the heat treatment of the step (c) may be carried out at a temperature in a range of room temperature to 200°C, preferably 40 to 180°C, and more preferably 80 to 150°C. Here, when the heat treatment is carried out below room temperature, the heat energy for the reaction of the perovskite precursor and the additive applied by the solution process and the crystallization of the thin film is not sufficient, and there is a concern about the formation of unstable crystals and oxidation due to the residual solvent and anti-solvent. When it is carried out above 200°C, the crystal structure is damaged, such as the generation of defects due to excessive heat energy, which is undesirable. The heat treatment may mean annealing, and the heat treatment means that the target is supplied with heat energy by maintaining the target at a constant temperature.

FIG. 2 shows a flow chart showing a manufacturing process diagram of a thin film transistor memory according to one embodiment of the present invention.

Referring to FIG. 2, the present disclosure provides a method of manufacturing a transistor memory, the method may comprise: (1) preparing a gate electrode/insulating layer laminate comprising a gate electrode and an insulating layer located on the gate electrode; (2) forming a semiconductor layer comprising a perovskite according to claim 1 on the insulating layer; and (3) forming a source electrode and a drain electrode on the semiconductor layer.

The present invention is comprising a compound denoted by the structural formula 1, a compound denoted by structural formula 2, and a metal fluoride compound, which suppresses the generation of oxidation and pore defects, thereby controlling the hole concentration and improving stability, improving crystallinity, and imparting memory characteristics to form an optimal memory semiconductor thin film. In particular, the role of the compound represented by the structural formula 1 and the metal fluoride compound is significant.

Here, the ammonium iodide based additive, the diammonium halide based additive, and the metal fluoride based additive commonly suppress the oxidation of tin and the generation of vacancy defects, and control the hole concentration when manufacturing a thin film through spin coating. In addition, the diammonium halide based additive forms a hollow structure in the thin film local area to induce a deep trap, thereby imparting memory characteristics to the thin film crystal, and the metal fluoride based additive can provide uniform crystal nuclei to induce the formation of a stable, uniform, and highly crystalline thin film crystal.

Tin-based halide perovskites are very unstable to oxygen and moisture in the atmosphere. This is because the material itself is strongly ionic, but the main reason is that tin is easily oxidized when it encounters moisture or oxygen. A very slight oxidation and the formation of Sn²⁺ vacancy induce hole self-doping, which leads to excellent p-type characteristics. However, excessively oxidized tin and the formation of excessive Sn²⁺ vacancy in the perovskite induce the instability of the crystal structure and the deterioration of excellent electrostatic characteristics, which ultimately leads to the collapse of the crystal structure. Therefore, the tin-based perovskite thin film of the present invention comprises various additives to control p doping and to suppress oxidation and vacancy formation.

In the case of a compound represented by the structural formula 1 of the present invention, it is an additive that induces a hollow structure in a thin film that causes the semiconductor layer to have memory characteristics. In the case of EDAI₂, it is ionized into EDA²⁺ and two I⁻ in the entire solution, and EDA²⁺ is comprised in the A cation position, and I⁻ can also be comprised in the X⁻ position. At this time, in the case of EDA²⁺, unlike the general A cation, it is a divalent cation, so in order to balance the charge, the existing A cation, FA⁺, or B cation, Sn²⁺, can be additionally comprised less.

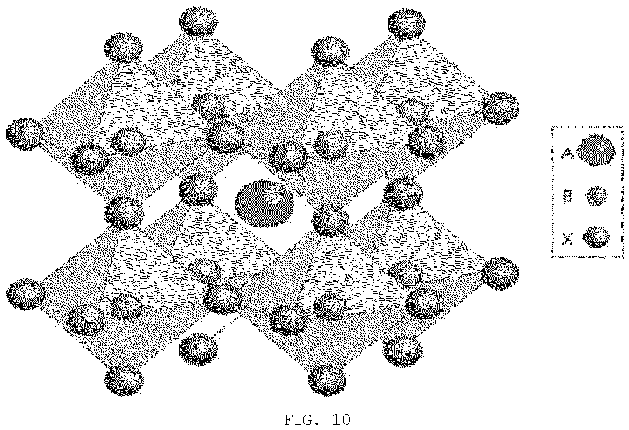

In addition, in the case of FAI, it is completely ionized in the solvent and exists in the solution in the form of FA⁺(CH(NH₂)₂⁺) and I⁻, and in the case of SnI₂, it is also completely ionized in the solvent and exists in the solution in the form of Sn²⁺ and I⁻. In the ABX₃ type perovskite lattice, FA⁺ forms a monovalent cation, A⁺, Sn²⁺ forms a divalent cation, B²⁺, and I⁻ forms a monovalent anion, X⁻. Referring to FIG. 10, B²⁺ and X⁻ form an octahedral structure, which are repeatedly connected through corner sharing, and A⁺ cations are inserted between these octahedrals to finally form the perovskite lattice structure.

In addition to FA⁺, materials that can be used as A cation may comprise Cs⁺, MA⁺ (Methylammonium, CH₃NH₃⁺), and in this case, CsI and MAI can be used instead of FAI in the first step of making the first mixed solution. Of course, A cation is not only comprised as a single material, but the three materials presented can be comprised alone or mixed in different ratios of two or three, and instead, the sum of their moles only needs to be in a ratio of 1:1 with the amount of Sn²⁺ in the precursor and a ratio of 1:3 with the amount of X⁻. PEAI and EDAI are also completely ionized into PEA⁺ and I⁻, and EDA²⁺ and I⁻ when dissolved in a solvent.

In addition, the metal fluoride compound of the present invention may play a role in inhibiting oxidation. SnF₂ is the most commonly known and widely used additive. When a metal fluoride compound is not comprised, the control of self p doping and oxidation inhibition are not achieved unless another oxidation inhibitor is added. So tin-based halide perovskite shows characteristics closer to that of conductor than semiconductor and is very unstable.

In addition, the additive may further comprise a compound represented by structural formula 2, and the compound represented by structural formula 2 may comprise an ammonium iodide-based compound.

The compound represented by structural formula 2 of the present invention may form a special structure that is somewhat resistant to tin oxidation, and thus can form a stable tin-based halide perovskite thin film.

In addition, the compound represented by structural formula 2, which is a large-sized organic cation, cannot be introduced into the lattice of ABX₃ due to its size, but a monovalent cation having an ammonium group can be bound to the A cation site, and in this case, the growth of the perovskite lattice no longer occurs in the corresponding direction, and the cation of the compound represented by structural formula 2 is attached to the lattice surface to fill the A cation site, thereby completing the growth of the crystal.

Therefore, when a compound represented by structural formula 2 is comprised to form a perovskite crystal thin film, a continuous bulk 3D crystal is not formed in all three-dimensional directions, but grains and crystals are formed in the form of a collection of flakes with various thicknesses with limited growth on one side, which is called a 2D/3D (2D-3D) structure.

Because of its large size and hydrophobic property, the compound represented by structural formula 2 can prevent moisture and oxygen from penetrating into the perovskite lattice, thereby preventing oxidation, and can create a relatively stable thin film. The results of comprising a compound represented by structural formula 2 to demonstrate stable memory device operation are attached to the examples and drawings below.

Then, the prepared precursor solution is dropped on a HfO₂/p⁺⁺ Si substrate and then spin coated to apply it to the substrate. Then, the substrate on which the film is applied is heated to complete the perovskite thin film crystal. Afterwards, gold is deposited through thermal evaporation to form detached source/drain electrodes, and finally a perovskite memory with a BGTC structure as shown in FIG. 1 is fabricated.

### [Example]

Hereinafter, the examples of the present disclosure will be described. However, the examples are for illustrative purposes, and the scope of the present disclosure is not limited by the examples.

### Fabrication of semiconductor layer comprising perovskite composite

### Example 1: Use of EDAI₂ + SnF₂ + PEAI additives

### Example 1-1: EDAI₂ 1 mol:SnF₂ 10 mol:PEAI 20 mol

FIG. 2 is a flow chart showing a manufacturing process diagram of a thin film transistor memory according to one embodiment of the present invention.

Referring to FIG. 2, after preparing the precursor solution of the perovskite composite, it was applied on a hafnium oxide/silicon (HfO₂/Si⁺⁺) substrate and then spin-coated to form a tin-based perovskite semiconductor thin film.

Specifically, FAI (Formamidinium Iodide, CH(NH₂)₂I) and SnI₂ (Tin iodide) were mixed with N,N-Dimethylformamide (DMF) and Dimethylsulfoxide (DMSO) co-solvent (DMF:DMSO = 4:1 (vol:vol)) to 0.18 M and 0.2 M, respectively, to prepare the first mixed solution.

Here, in the case of FAI, it is completely ionized in the solvent and exists in the solution in the form of FA⁺(CH(NH₂)₂⁺) and I⁻, and in the case of SnI₂, it is also completely ionized in the solvent and exists in the solution in the form of Sn²⁺ and I⁻. In the perovskite lattice of ABX₃ type, FA⁺ forms a monovalent cation A⁺, Sn²⁺ forms a divalent cation B²⁺, and I⁻ forms a monovalent anion X⁻. Referring to FIG. 10, B²⁺ and X⁻ form an octahedral structure, which is repeatedly connected through corner sharing, and A⁺ cations are inserted between these octahedrals to finally form the perovskite lattice structure.

In addition to FA⁺, a material that can be used as A cation can also comprise Cs⁺, MA⁺(Methylammonium, CH₃NH₃⁺), in which case CsI and MAI can be used instead of FAI in the first step of making the first mixed solution. Of course, A cation is not only comprised as a single material, but the three materials presented can be comprised alone or mixed in different ratios of two or three. Instead, the sum of their moles only needs to be in a ratio of 1:1 with the amount of Sn²⁺ in the precursor and a ratio of 1:3 with the amount of X⁻.

In the manufactured perovskite precursor solution, EDAI₂, SnF₂, and PEAI were added so that the molar ratio of tin: EDAI₂: tin fluoride (SnF₂): PEAI was 100 mol:1 mol:10 mol:20 mol based on 100 mol of tin, to prepare a second mixed solution.

The second mixed solution was heated at a temperature of about 60°C for 2 to 3 hours to prepare a precursor solution.

The precursor solution was dropped onto a HfO₂/Si⁺⁺ substrate and spin-coated at a speed of 5 krpm (rotations per minute) for 60 seconds. Afterwards, a semiconductor layer comprising a perovskite composite comprising 1 mol of EDAI₂, 10 mol of SnF₂, and 20 mol of PEAI based on 100 mol of tin-based perovskite was manufactured by heat treatment at 100°C for 10 minutes.

### Example 1-2: EDAI₂ 2 mol:SnF₂ 10 mol:PEAI 20 mol

The semiconductor layer comprising the perovskite composite was prepared in the same manner as in Example 1-1, except that EDAI₂, tin fluoride, and PEAI were added to the first mixed solution so that the molar ratio of tin:EDAI₂:tin fluoride (SnF₂):PEAI was 100 mol:2 mol:10 mol:20 mol based on 100 mol of tin in the finally prepared perovskite composite when preparing the second mixed solution, .

### Example 1-3: EDAI₂ 4 mol:SnF₂ 10 mol:PEAI 20 mol

The semiconductor layer comprising the perovskite composite was prepared in the same manner as in Example 1-1, except that EDAI₂, tin fluoride, and PEAI were added to the first mixed solution so that the molar ratio of tin:EDAI₂:tin fluoride (SnF₂):PEAI was 100 mol:4 mol:10 mol:20 mol based on 100 mol of tin in the finally prepared perovskite composite when preparing the second mixed solution, .

### Comparative Example 1: SnF₂ 10 mol:PEAI 20 mol (Compound represented by structural formula 1 was not used)

A semiconductor layer comprising a perovskite composite was prepared in the same manner as in Example 1-1, except that EDAI₂ (a compound represented by structural formula 1) was not added when preparing the second mixed solution.

Table 1 below shows the molar ratio of each additive for 100 mol of tin in Examples 1-1 to 1-3 and Comparative Example 1.

**[Table 1]**

| category | Molar Ratio | | | |
|---|---|---|---|---|
| | Tin (mol) | Compound represented by structural formula 1 | Metal fluoride compound | Compound represented by structural formula 2 |
| | | EDAI₂ | SnF₂ | PEAI |
| Example 1-1 | 100 | 1 | 10 | 20 |
| Example 1-2 | 100 | 2 | 10 | 20 |
| Example 1-3 | 100 | 4 | 10 | 20 |
| Comparative Example 1 | 100 | - | 10 | 20 |

### Manufacture of thin film transistors

### Device Example 1-1 to 1-3

FIG. 1 is a schematic diagram of a thin film transistor memory according to one embodiment of the present invention, and FIG. 2 is a flow chart showing a manufacturing process diagram of a thin film transistor memory according to one embodiment of the present invention.

Referring to FIGs. 1 and 2, transistors of device examples 1-1 to 1-3 were manufactured. First, the precursor solutions manufactured in each of Examples 1-1 to 1-3 were dropped onto HfO₂ of a HfO₂/Si⁺⁺ substrate and spin-coated at a speed of 5 krpm (rotations per minute) for 60 seconds. Afterwards, a semiconductor layer comprising a perovskite composite was manufactured by heat treatment at 100° C. for 10 minutes.

Au electrodes were thermally evaporated on the semiconductor layer to form source and drain electrodes, thereby manufacturing a thin film transistor (a perovskite memory with a BGTC structure).

### Device Comparative Example 1

A thin film transistor was manufactured in the same manner as in Device Example 1-1 except for using the precursor solution manufactured in Comparative Example 1.

Table 2 below shows the semiconductor layers used in Device Examples 1-1 to 1-3.

**[Table 2]**

| category | Perovskite composite semiconductor layer |
|---|---|
| Device Example 1-1 | Example 1-1 |
| Device Example 1-2 | Example 1-2 |
| Device Example 1-3 | Example 1-3 |
| Device Comparative Example 1 | Comparative Example 1 |

### [Test Example]

### Test Example 1: Analysis of change in crystal lattice and optical property due to addition of metal fluoride compound and confirmation of formation of hollow structure

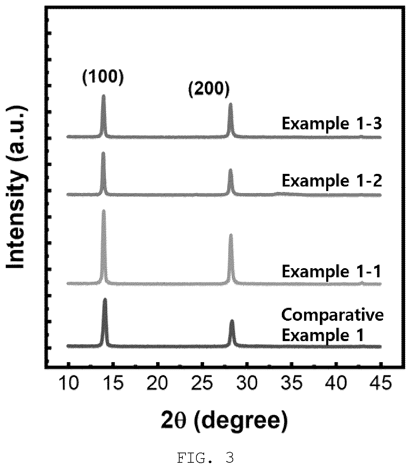

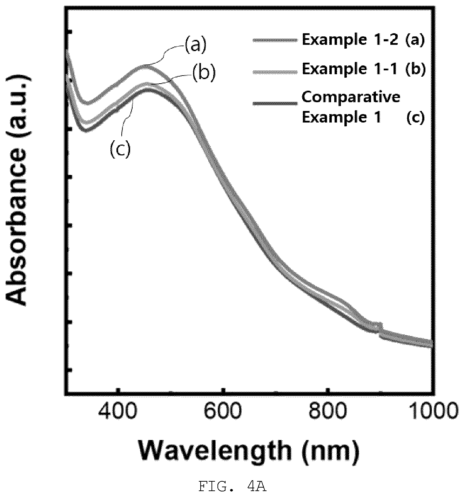

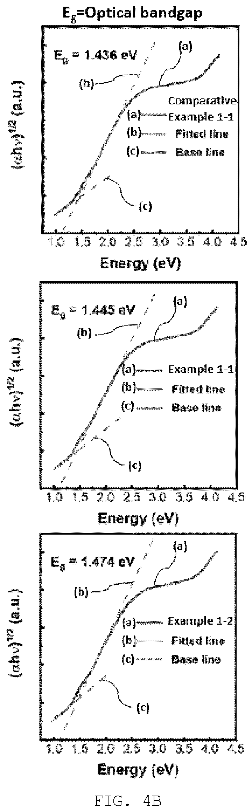

FIG. 3 is the XRD analysis showing results of Examples 1-1, 1-2, and 1-3 and Comparative Example 1, FIG. 4A shows the absorbance analysis showing results of Examples 1-1, 1-2 and Comparative Example 1, and FIG. 4B shows the results of Tauc plot extrapolation for deriving the optical bandgap of Examples 1-1, 1-2 and Comparative Example 1.

Referring to FIG. 3, it can be confirmed that the peaks of Example 1-1 are transferred to a smaller θ overall compared to Comparative Example 1 where EDAI₂ is not added to the tin-based perovskite, and the degree is more severe in Examples 1-2 and 1-3 where a larger amount of the compound represented by Structural Formula 1 is added. The transfer of the peak to a smaller θ generally means that the lattice constant has increased, which explains that a hollow structure has been created within the lattice.

In detail, EDA²⁺ of EDAI₂ is larger in size than the general cations such as Cs⁺, FA⁺, and MA⁺, etc., that can be comprised in B, C, and D in Structural Formula 1, and accordingly, when introduced into the lattice, the lattice constant increases, showing a transfer of the peak to a smaller Θ.

In addition, when compared with Comparative Example 1, the peak sizes of Examples 1-1, 1-2, and 1-3 are larger, it can be seen that the crystallinity is superior when EDAI₂ is added. Specifically, EDA²⁺, which has two ammonium groups, actively interacts with the perovskite constituent ions, allowing the crystal to grow more slowly, improving the quality of the thin film and exhibiting stable electrical characteristics.

Referring to FIG. 4, it can be seen that the optical bandgap E_{g} increases as more EDAI₂ is added to the tin-based perovskite. The reason for this increase in optical bandgap is that the number of Sn²⁺ forming the conduction band (CB) and valence band (VB) decreased as EDA²⁺ took the place of FA⁺ and Sn²⁺ in the bulk lattice, and thus the thickness of the VB and CB became thinner. So it was confirmed that a hollow structure was formed.

### Test Example 2: confirmation of transistor characteristic according to the molar ratio of added EDAI₂

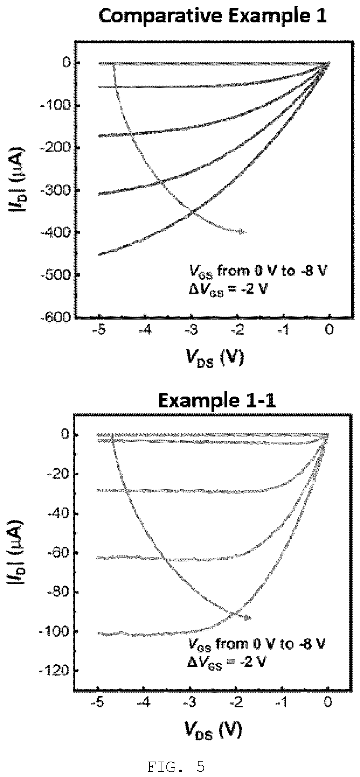

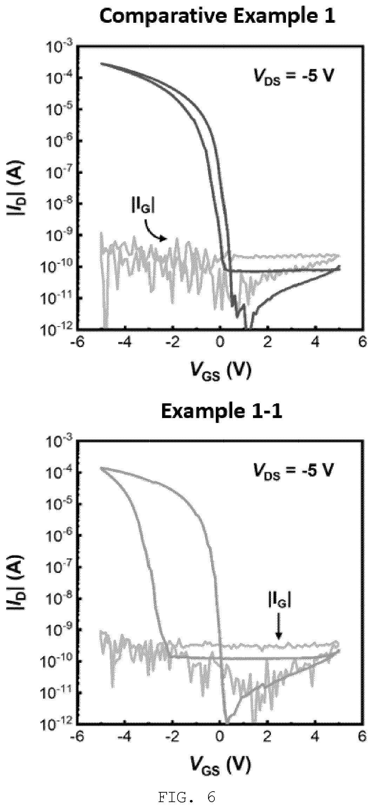

FIG. 5 shows the current curves (output curves) of Device Example 1-1 and Device Comparative Example 1, FIG. 6 shows the transfer curves of Device Example 1-1 and Device Comparative Example 1 when V_{DS}= -5 V is set. Specifically, FIG. 5 shows the current (I_{DS}) flowing through the active layer according to the application of the drain voltage when the voltage (V_{GS}) between the gate electrode and the source electrode is set to -8 to 0 V, and FIG. 6 shows the current (I_{DS}) flowing through the active layer according to the application of the gate voltage (in this case, the voltage between the source electrode and the drain electrode is -5 V (V_{DS} = -5 V)).

Referring to FIGs. 5 and 6, it was confirmed that the perovskite transistor manufactured according to the present invention exhibited the characteristic of a typical P-type transistor.

In addition, referring to FIG. 5, I_{DS} showed a linear increase with the increase in V_{DS} in the linear region, and this showed the same result in all V_{GS}, and through this, it was confirmed that the contact between the semiconductor layer and the source and drain electrodes was well formed.

In addition, referring to FIG. 6, both the device example 1-1 and the device comparative example 1 have excellent characteristics with a current on/off ratio (I_{on/off}) of 10⁶ or more, but the on current was slightly lowered due to the hole generation suppression effect of the compound represented by structural formula 1, and accordingly, the field-effect transistor hole mobility (µ_{FET}) slightly decreased from 7.49 cm²/V·s to 5.79 cm²/V·s. In addition, it was confirmed that the hysteresis phenomenon of the transition curve was greatly expanded when the compound represented by structural formula 1 was added.

### Test Example 3: confirmation of memory characteristic according to the molar ratio of added EDAI₂

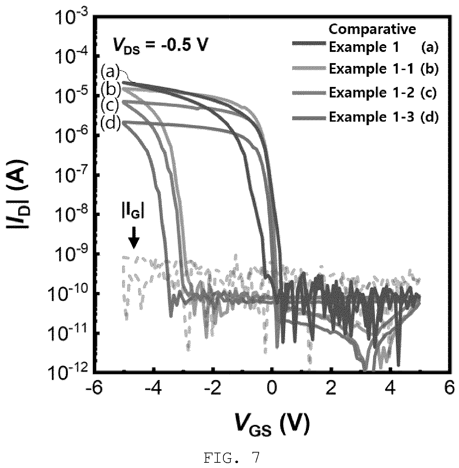

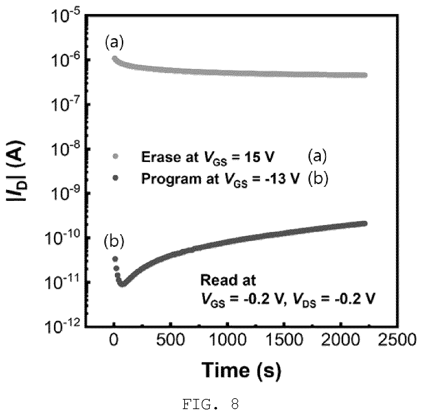

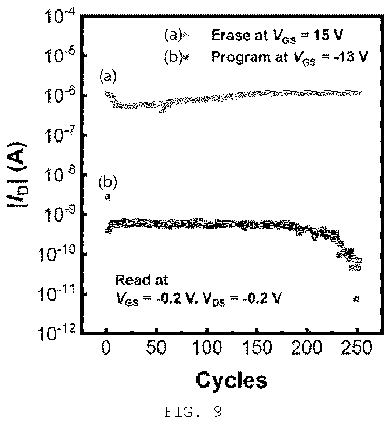

FIG. 7 shows the transfer curves of device examples 1-1 to 1-3 and device comparative example 1 when V_{DS} = -0.5 V is set, FIG. 8 shows the result of measuring the retention time of stored information for device example 1-1, and FIG. 9 shows the result of measuring the cycling endurance for device example 1-1.

Referring to FIG. 7, in the case of Device Comparative Example 1 where the compound (EDAI₂) represented by Structural Formula 1 was not added, the hysteresis phenomenon was found to be small, in the same way as when V_{DS} = -5 V was applied, but in the case of Examples 1-1 to 1-3 where the compound represented by Structural Formula 1 was added, the hysteresis phenomenon was confirmed to be very large. Specifically, when the additive is added, a hollow structure is formed by introducing it into the bulk lattice instead of the existing cations, and accordingly, a deep trap occurs in the channel part of the semiconductor layer, causing the hysteresis phenomenon as described above, and it can be confirmed that the characteristics of the memory resistor are formed.

Referring to FIG. 8, a pulse corresponding to V_{GS} = -13 V was applied for 2 seconds to switch to the Program state, a pulse corresponding to V_{GS} = 15 V was applied for 4 seconds to switch to erase state, and voltages corresponding to V_{GS} = -0.2 V and V_{DS} = - 0.2 V were applied to read the information. As a result, the information was stably maintained for more than 10³ seconds with I_{on/off}, which is the difference between the current value (I_{DS}) of the program state and the erase state, maintained at 10³ or more, and it was confirmed that excellent non-volatile memory characteristics could be imparted to the transistor by adding a compound represented by structural formula 1.

Referring to FIG. 9, pulse corresponding to V_{GS} = -13 V was applied for 2 seconds to switch to the program state, pulse corresponding to V_{GS} = 15 V was applied for 4 seconds to switch to the erase state, and voltage corresponding to V_{GS} = -0.2 V and V_{DS} = -0.2 V was applied to read the information.

As shown in FIG. 9, even after 250 switching cycles, I_{on/off} remained at 10³ or more, and stable write/erase/read characteristics showed. In other words, it was confirmed that excellent nonvolatile memory characteristics can be imparted to the transistor by adding a compound represented by structural formula 1 by the cycle endurance measurement.

The scope of the present disclosure is defined by the following claims rather than the detailed description, and all changes or modifications derived from the meaning and scope of the claims and their equivalent concepts should be interpreted as falling into the scope of the present disclosure.

## Claims

1. A perovskite comprising:
at least one selected from the group consisting of cesium (Cs), methylammonium (MA) and formamidinium (FA);
a compound represented by structural formula 1;
at least one selected from the group consisting of fluorine (F), chlorine (Cl), bromine (Br) and iodine (I); and
tin (Sn). 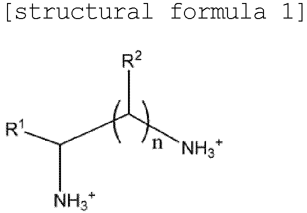
in the structural formula 1,
R¹ is a hydrogen atom, a methyl group or an ethyl group,
R² is a hydrogen atom, a methyl group or an ethyl group, and
n is anyone of integers 1 to 3.

2. The perovskite of claim 1, wherein the compound represented by the structural formula 1 comprises at least one selected from the group consisting of ethane-1,2-diammonium (EDA), propane-1,2-diammonium (P2DA), propane-1,3-diammonium (P3DA), Piperazine-1,4-diium iodide, Piperazine-1,4-diium chloride and Piperazine-1,4-diium bromide.

3. The perovskite of claim 1, having a hollow structure within a lattice.

4. The perovskite of claim 1, further comprising a compound represented by structural formula 2. 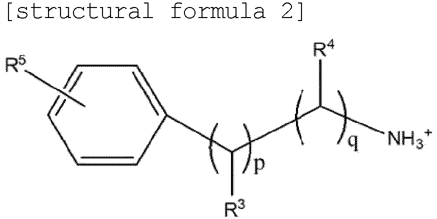 in the structural formula 2,
R³ is a hydrogen atom, a methyl group, or an ethyl group,
R⁴ is a hydrogen atom, a methyl group or an ethyl group,
R⁵ is a hydrogen atom, a methyl group, an ethyl group, a C6 to C10 aryl group or a C6 to C14 aryl group fused to the benzene ring,
p is anyone of integers 0 to 3, and
q is anyone of integers 1 to 3.

5. The perovskite of claim 4, comprising 0.1 to 100 mol of at least one selected from the group consisting of the compound represented by the structural formula 1 and the compound represented by the structural formula 2 on the basis of 100 mol of the tin.

6. The perovskite of claim 4, comprising a 2D/3D (quasi 2D) structure.

7. The perovskite of claim 4, wherein the compound represented by the structural formula 2 is located on a surface of the perovskite crystal.

8. The perovskite of claim 1, comprising a grain boundary formed between a grain and a neighboring grain, and
wherein at least one metal fluoride compound selected from the group consisting of SnF₂ and SbF₃ is located at the grain boundary.

9. The perovskite of claim 1, which is used in a semiconductor layer of at least one device selected from the group consisting of a memory device, a transistor, a solar cell, a light-emitting diode, a photodiode and a photosensor.

10. The perovskite of claim 9, wherein a thickness of the semiconductor layer is in a range of 1 to 100 nm.

11. A transistor memory comprising:
a gate electrode;
an insulating layer located on the gate electrode;
a semiconductor layer comprising a perovskite located on the insulating layer; and
a source electrode and a drain electrode located at a distance from each other on the semiconductor layer.

12. The transistor memory of claim 11, wherein the perovskite comprising:
at least one selected from the group consisting of cesium (Cs), methylammonium (MA) and formamidinium (FA);
a compound represented by structural formula 1;
at least one selected from the group consisting of fluorine (F), chlorine (Cl), bromine (Br), and iodine (I); and
tin (Sn). 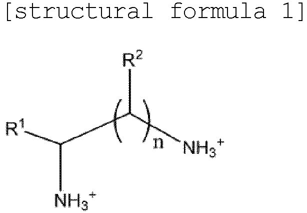
in the structural formula 1,
R¹ is a hydrogen atom, a methyl group or an ethyl group,
R² is a hydrogen atom, a methyl group or an ethyl group, and
n is anyone of integers 1 to 3.

13. A method of preparing a perovskite, the method comprising:
(a) preparing a precursor solution comprising a tin precursor, a compound represented by structural formula 1', a solvent and at least one selected from the group consisting of a cesium (Cs) precursor, a methylammonium (MA) precursor and a formamidinium (FA) precursor;
(b) coating the precursor solution on a substrate to form a coating layer; and
(c) heat-treating the coating layer to prepare a perovskite. 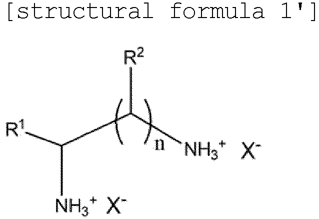 in the structural formula 1',
R¹ is a hydrogen atom, a methyl group or an ethyl group,
R² is a hydrogen atom, a methyl group, or an ethyl group,
X is F, Cl, Br or I and
n is anyone of integers 1 to 3.

14. The method of claim 13, wherein the precursor solution further comprises a compound represented by structural formula 2'. 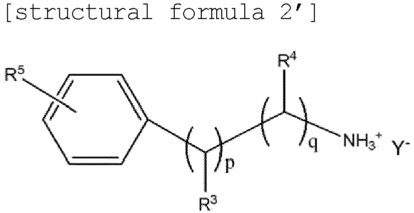 in the structural formula 2',
R³ is a hydrogen atom, a methyl group or an ethyl group,
R⁴ is a hydrogen atom, a methyl group or an ethyl group,
R⁵ is a hydrogen atom, a methyl group, an ethyl group, a C6 to C10 aryl group or a C6 to C14 aryl group fused to the benzene ring,
Y 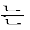 F, Cl, Br or I,
p is anyone of integers 0 to 3, and
q is anyone of integers 1 to 3.

15. The method of claim 13, wherein the coating of the step (b) is carried out by at least one method selected from the group consisting of spin coating, bar coating, slot coating, inkjet coating, spray coating, dispensing, thermal evaporation, chemical vapor deposition (CVD), atomic layer deposition (ALD), sputtering, flexography, screen, dip-coating and gravure method.
